(19) **Europäisches Patentamt** / **European Patent Office** / **Office européen des brevets**

(11) **EP 4 113 131 B1**

(12) **FASCICULE DE BREVET EUROPEEN**

(45) Date de publication et mention de la délivrance du brevet:
**25.10.2023 Bulletin 2023/43**

(21) Numéro de dépôt: **22180271.3**

(22) Date de dépôt: **21.06.2022**

(51) Classification Internationale des Brevets (IPC):
**G01R 22/06** *(2006.01)*    **G01R 22/10** *(2006.01)*
*G01R 11/24* *(2006.01)*

(52) Classification Coopérative des Brevets (CPC):
**G01R 22/066; G01R 22/10;** G01R 11/24

(54) **ESTIMATION, MALGRE UNE FRAUDE, DE LA PUISSANCE CONSOMMEE SUR UNE PHASE**

SCHÄTZUNG DER AUF EINER PHASE VERBRAUCHTEN LEISTUNG TROTZ EINES BETRUGS

ESTIMATION, DESPITE FRAUD, OF THE POWER CONSUMED OVER A PHASE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.06.2021 FR 2107012**

(43) Date de publication de la demande:
**04.01.2023 Bulletin 2023/01**

(73) Titulaire: **Sagemcom Energy & Telecom SAS
92500 Rueil-Malmaison (FR)**

(72) Inventeurs:
- **TEBOULLE, Henri
  92500 RUEIL MALMAISON (FR)**
- **NOIRET, Sébastien
  92500 RUEIL MALMAISON (FR)**

(74) Mandataire: **Lavaud, Thomas
Cabinet Boettcher
5, rue de Vienne
75008 Paris (FR)**

(56) Documents cités:
EP-A2- 0 455 518     FR-A1- 2 991 057
US-A1- 2012 306 290     US-B1- 6 236 197

**Description**

L'invention concerne le domaine des compteurs électriques triphasés.

ARRIERE PLAN DE L'INVENTION

Les compteurs électriques, utilisés dans les applications industrielles, mesurent fréquemment des puissances et des énergies électriques qui sont distribuées via des niveaux de courant très élevés (jusqu'à 2000A typiquement). Ces compteurs sont généralement des compteurs triphasés.

Un tel compteur comporte des entrées de courant et des entrées de tension.

Des capteurs de courant, par exemple des capteurs de *Rogowski* ou des transformateurs de courant externes, sont classiquement montés sur les phases. Chaque capteur de courant est relié à une entrée de courant par deux fils conducteurs. Le compteur acquiert ainsi, pour chaque phase, une image du courant circulant sur ladite phase.

Chaque entrée de tension est classiquement reliée à une phase par un fil conducteur. Le compteur accède ainsi directement à la tension présente sur chaque phase via le fil conducteur associé.

Une fraude connue consiste à couper un ou des fils conducteurs qui relient les phases aux entrées de tension. Le but d'une telle fraude est de faire sous-évaluer l'énergie totale consommée qui est mesurée par le compteur, de manière à réduire la facture à payer au distributeur d'énergie électrique.

En cas de fraude, les compteurs de l'art antérieur continuent de réaliser les mesures métrologiques en l'état sur les trois phases, sans tenir compte de la fraude, et donc sous-évaluent effectivement l'énergie consommée. Même si la fraude est détectée, le distributeur ne connaît pas l'énergie réellement consommée par l'installation du fraudeur. Or, il peut s'avérer utile de connaître l'énergie réellement consommée, par exemple pour réclamer au fraudeur le paiement de l'énergie non facturée (en plus d'éventuelles pénalités visant à sanctionner la tentative de fraude).

EP 0 455 518 A2 divulgue un procédé d'estimation de la puissance consommée sur une phase , malgré une fraude, ou l'énergie consommée est estimée à partir d'une estimation du voltage sur la phase faussée et le curent mesurée sur cette phase.

US 2012/306290 A1 divulgue un procédé de contrôle d'un dispositif de coupage ou seulement une voltage est mesurée et les autres deux sont reconstituées par calcul, filtrage, déphasage de k*120° en tenant compte de la tension acquise.

US 6 236 197 B1 divulgue un procédé de détermination de fraude sur un système triphasée.

OBJET DE L'INVENTION

L'invention a pour objet d'estimer, malgré une fraude consistant à fausser des mesures de tension sur une phase, l'énergie totale consommée par une installation.

RESUME DE L'INVENTION

En vue de la réalisation de ce but, on propose un procédé d'estimation de puissance, mis en oeuvre dans un compteur électrique triphasé, et comprenant les étapes de :

- détecter une fraude qui fausse des mesures d'une première tension de phase présente sur une première phase d'un réseau de distribution, sans fausser de mesures d'une deuxième tension de phase présente sur une deuxième phase du réseau de distribution ;
- reconstituer des premiers échantillons de tension estimés, images dans le temps de la première tension de phase, à partir de deuxièmes échantillons de tension, images dans le temps de la deuxième tension de phase, les deuxièmes échantillons de tension étant décalés dans le temps d'un déphasage théorique attendu sans la fraude entre la première tension de phase et la deuxième tension de phase ;
- estimer au moins une première puissance électrique consommée sur la première phase en utilisant les premiers échantillons de tension estimés.

Lorsqu'une fraude est détectée sur la première phase, les mesures de la première tension de phase sont faussées et ne sont donc pas utilisables.

Le procédé d'estimation de puissance selon l'invention remplace donc les mesures de la première tension de phase par des premiers échantillons estimés qui sont reconstitués à partir des mesures de la deuxième tension de phase qui, elles, ne sont pas faussées par la fraude.

Le procédé estime ensuite les premières puissances électriques consommées sur la première phase en utilisant les premiers échantillons de tension estimés.

Le distributeur d'énergie peut donc obtenir, malgré la fraude, une estimation relativement précise des puissances électriques totales et de l'énergie totale réellement consommées par l'installation.

On propose de plus un procédé d'estimation de puissance tel que précédemment décrit, dans lequel la reconstitution comprend les étapes d'acquérir un premier décalage d'indice correspondant au déphasage théorique attendu et, pour chaque premier échantillon de tension estimé associé à un premier indice :

- si le premier décalage d'indice est un entier, de conférer au premier échantillon de tension estimé une valeur d'un deuxième échantillon de tension ayant pour deuxième indice le premier indice décalé du premier décalage d'indice ;
- sinon, de conférer au premier échantillon de tension estimé une valeur estimée obtenue à partir d'une interpolation utilisant au moins un deuxième échantillon de tension.

On propose de plus un procédé d'estimation de puissance tel que précédemment décrit, dans lequel le premier décalage d'indice $\Delta 1$ est tel que :

$$\Delta 1 = 2N/3 \text{ ou } \Delta 1 = N/3,$$

où N est un nombre de premiers échantillons de tension par période de la première tension de phase, et dans lequel, si $\Delta 1$ est un entier, on a :

$$U_{1_n} = V_{2_{n-\Delta 1}}.$$

On propose de plus un procédé d'estimation de puissance tel que précédemment décrit, comprenant l'étape, si $\Delta 1$ n'est pas un entier, de calculer la valeur estimée en réalisant une interpolation linéaire entre le deuxième échantillon de tension $V_{2_{n-INT(\Delta 1)-1}}$ et le deuxième échantillon de tension $V_{2_{n-INT(\Delta 1)}}$, INT étant la fonction partie entière.

On propose de plus un procédé d'estimation de puissance tel que précédemment décrit, dans lequel la reconstitution comprend les étapes de :

- acquérir une table de référence préenregistrée et contenant des échantillons de référence d'un signal sinusoïdal ;
- mesurer une valeur maximale de la deuxième tension de phase et multiplier les échantillons de référence par un facteur d'amplitude proportionnel à la valeur maximale pour obtenir des échantillons de référence résultants, et

pour chaque premier échantillon de tension estimé associé à un premier indice, conférer au premier échantillon de tension estimé une valeur d'un échantillon de référence résultant ayant pour indice le premier indice décalé d'un décalage d'indice correspondant au déphasage théorique attendu sans la fraude entre la première tension de phase et la deuxième tension de phase.

On propose de plus un procédé d'estimation de puissance tel que précédemment décrit, dans lequel la au moins une première puissance électrique comprend une première Puissance Active estimée à partir des premiers échantillons de tension estimés et de premiers échantillons de courant, images dans le temps d'un premier courant de phase circulant sur la première phase, et/ou une première Puissance Réactive estimée à partir d'échantillons d'un niveau sur une fréquence fondamentale de la première tension de phase et d'échantillons d'un niveau sur une fréquence fondamentale du premier courant de phase, et/ou une première Puissance Apparente estimée à partir d'une valeur efficace de la première tension de phase et d'une valeur efficace du premier courant de phase.

On propose de plus un procédé d'estimation de puissance tel que précédemment décrit, dans lequel les échantillons du niveau sur la fréquence fondamentale de la première tension de phase et les échantillons du niveau sur la fréquence fondamentale du premier courant de phase sont obtenus par application d'un filtre passe-bas respectivement sur les premiers échantillons de tension estimés et sur les premiers échantillons de courant.

On propose de plus un procédé d'estimation de puissance tel que précédemment décrit, dans lequel le filtrage passe-bas est un filtre de *Butterworth* du premier ordre ayant une transformée en Z $H(Z)$ telle que :

$$H(Z) = \frac{1+Z^{-1}}{1-a.Z^{-1}},$$

avec :

$$a = 0.7569801925.$$

On propose de plus un procédé d'estimation de puissance tel que précédemment décrit, comprenant en outre les étapes, si la fraude fausse aussi des mesures d'une troisième tension de phase, présente sur une troisième phase, d'utiliser à nouveau les deuxièmes échantillons de tension pour reconstituer des troisièmes échantillons de tension estimés, images dans le temps de la troisième tension de phase, et d'estimer au moins une troisième puissance électrique consommée sur la troisième phase en utilisant les troisièmes échantillons de tension estimés.

On propose de plus un procédé d'estimation de puissance tel que précédemment décrit, comprenant en outre les étapes de détecter si le réseau de distribution comprend ou non un neutre en plus des trois phases et, si ce n'est pas le cas, de calculer des deuxièmes échantillons de tension corrigés, et de calculer au moins une deuxième puissance électrique corrigée consommée sur la deuxième phase à partir des deuxièmes échantillons de tension corrigés.

On propose de plus un procédé d'estimation de puissance tel que précédemment décrit, dans lequel le calcul des deuxièmes échantillons de tension corrigés comprend les étapes d'acquérir un deuxième décalage d'indice correspondant à un déphasage théorique attendu pour les mesures de la deuxième tension de phase du fait de la fraude, de multiplier les deuxièmes échantillons de tension par un facteur prédéterminé pour obtenir des deuxièmes échantillons résultants et, pour chaque deuxième échantillon de tension corrigé associé à un deuxième indice corrigé :

- si le deuxième décalage d'indice est un entier, de conférer au deuxième échantillon de tension corrigé une valeur d'un deuxième échantillon de tension résultant ayant pour deuxième indice le deuxième indice corrigé décalé du deuxième décalage d'indice ;
- sinon, conférer au deuxième échantillon de tension corrigé une valeur estimée obtenue à partir d'une interpolation utilisant au moins un deuxième échantillon de tension résultant.

On propose de plus un procédé d'estimation de puissance tel que précédemment décrit, dans lequel une absence de neutre est détectée lorsqu'un angle φ entre la deuxième tension de phase et la troisième tension de phase est tel que :

$$180° - X° < |\varphi| < 180° + X°,$$

X étant une valeur prédéfinie positive et inférieure à 30.

On propose de plus un procédé d'estimation de puissance tel que précédemment décrit, dans lequel la fraude est détectée lorsque la première tension de phase est inférieure à un seuil de tension prédéfini alors que le premier courant de phase est supérieur à un seuil de courant prédéfini.

On propose de plus un compteur électrique triphasé, comprenant un composant de traitement agencé pour mettre en oeuvre le procédé d'estimation de puissance tel que précédemment décrit.

On propose de plus un programme d'ordinateur comprenant des instructions qui conduisent le composant de traitement du compteur électrique triphasé tel que précédemment décrit à exécuter les étapes du procédé d'estimation de puissance tel que précédemment décrit.

On propose de plus un support d'enregistrement lisible par ordinateur, sur lequel est enregistré le programme d'ordinateur tel que précédemment décrit.

L'invention sera mieux comprise à la lumière de la description qui suit de modes de mise en oeuvre particuliers non limitatifs de l'invention.

BREVE DESCRIPTION DES DESSINS

Il sera fait référence aux dessins annexés parmi lesquels :

[Fig. 1] la figure 1 représente un compteur électrique triphasé selon l'invention, dans une configuration à quatre fils ;
[Fig. 2] la figure 2 représente un graphique comprenant une courbe sinusoïdale, et permet d'illustrer une méthode d'interpolation linéaire ;
[Fig. 3] la figure 3 représente un compteur électrique triphasé selon l'invention, dans une configuration à trois fils ;
[Fig. 4] la figure 4 représente, dans la configuration à quatre fils, les diagrammes de Fresnel des tensions et des courants mesurés sur les phases dans le cas normal (à gauche), et en cas de fraude (à droite) ;
[Fig. 5] la figure 5 est une figure similaire à la figure 4, mais dans une configuration à trois fils ;
[Fig. 6] la figure 6 est un organigramme représentant les étapes du procédé d'estimation de puissance selon l'invention.

DESCRIPTION DETAILLEE DE L'INVENTION

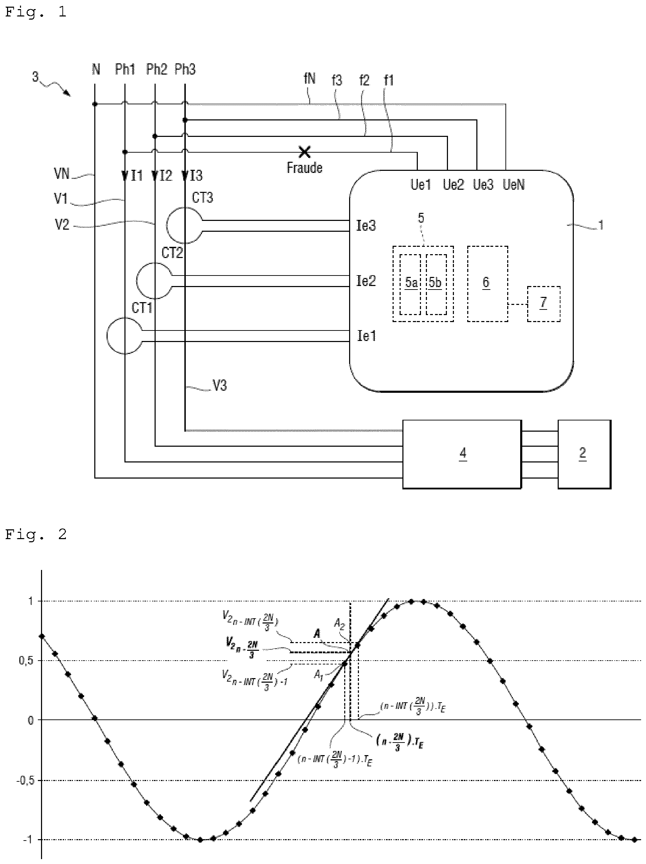

En référence à la figure 1, le procédé d'estimation de puissance selon un premier mode de réalisation de l'invention est mis en oeuvre dans un compteur électrique triphasé 1 qui est destiné à mesurer l'énergie électrique fournie à l'installation 2 d'un abonné par un réseau de distribution 3. Cette installation 2 est une installation industrielle.

On se place ici dans une configuration à quatre fils.

Le réseau de distribution 3 comprend donc une première phase Ph1, une deuxième phase Ph2, une troisième phase Ph3 et un neutre N. Un disjoncteur 4 est positionné « à la frontière » entre le réseau de distribution 3 et l'installation 2. Les trois phases Ph1, Ph2, Ph3 et le neutre N rentrent dans le disjoncteur 4 et en ressortent vers l'installation 2. Le disjoncteur 4 permet de couper la distribution d'énergie électrique.

Le compteur 1 comprend quatre entrées de tension Ue1, Ue2, Ue3, UeN et trois entrées de courant Ie1, Ie2, Ie3 (chaque entrée de courant comprenant deux ports).

L'entrée de tension Ue1 est reliée à la première phase Ph1 par un fil conducteur f1, l'entrée de tension Ue2 est reliée à la deuxième phase Ph2 par un fil conducteur f2, l'entrée de tension Ue3 est reliée à la troisième phase Ph3 par un fil conducteur f3 et l'entrée de tension UeN est reliée au neutre N par un fil conducteur fN.

L'entrée de courant Ie1 est reliée à un transformateur de courant externe CT1 monté sur la première phase Ph1, l'entrée de courant Ie2 est reliée à un transformateur de courant externe CT2 monté sur la deuxième phase Ph2, et l'entrée de courant Ie3 est reliée à un transformateur de courant externe CT3 monté sur la troisième phase Ph3. Les transformateurs de courant externes sont situés à l'extérieur du compteur 1.

Chaque transformateur de courant externe présente ici un rapport de transformation égal à 2000.

Pour réaliser les mesures métrologiques, le compteur 1 récupère, au niveau des entrées de courant Ie1, Ie2, Ie3, et grâce aux transformateurs externes CT1, CT2 et CT3, une image des courants de phase I1, I2, I3 circulant sur les phases Ph1, Ph2 et Ph3. Le compteur 1 récupère aussi, sur les entrées de tension Ue1, Ue2, Ue3 et UeN, les tensions de phase V1, V2, V3 présentes sur les phases Ph1, Ph2, Ph3 et la tension de neutre VN présente sur le neutre N.

Le compteur 1 comporte de plus des composants de mesure 5 comprenant des composants frontaux 5a et des convertisseurs analogiques numériques 5b (ou bien un seul convertisseur analogique numérique ayant un nombre d'entrées suffisant).

Les composants frontaux 5a sont reliés aux entrées de courant et aux entrées de tension. Les composants frontaux 5a permettent de transformer les courants sur les entrées de courant en tensions adaptées aux convertisseurs analogiques numériques 5b. Les composants frontaux 5a permettent aussi de transformer les tensions sur les entrées de tensions en tensions adaptées aux convertisseurs analogiques numériques 5b.

Le compteur 1 comporte de plus un composant de traitement 6.

Le composant de traitement 6 est adapté à exécuter des instructions d'un programme pour mettre en oeuvre le procédé d'estimation de puissance selon l'invention. Le programme est stocké dans une mémoire 7, qui est intégrée dans ou reliée au composant de traitement 6. Le composant de traitement 6 est par exemple un processeur classique, un microcontrôleur, un DSP (pour *Digital Signal Processor*, que l'on peut traduire par « processeur de signal numérique »), ou bien un circuit logique programmable tel qu'un FPGA (pour *Field Programmable Gate Arrays*) ou un ASIC (pour *Application Spécifie Integrated Circuit*).

Ici, le composant de traitement 6 est un microcontrôleur 6.

Le microcontrôleur 6 est relié aux convertisseurs analogiques numériques 5b et acquiert les échantillons de mesure produits par les convertisseurs analogiques numériques 5b.

Le microcontrôleur 6 acquiert ainsi des premiers échantillons de tension $V_{1_n}$ et des premiers échantillons de courant $I_{1_n}$, images dans le temps respectivement de la première tension de phase V1 et du premier courant de phase I1. Le microcontrôleur 6 acquiert aussi des deuxièmes échantillons de tension $V_{2_n}$ et des deuxièmes échantillons de courant $I_{2_n}$, images dans le temps respectivement de la deuxième tension de phase V2 et du deuxième courant de phase I2. Le microcontrôleur acquiert aussi des troisièmes échantillons de tension $V_{3_n}$ et des troisièmes échantillons de courant $I_{3_n}$, images dans le temps respectivement de la troisième tension de phase V3 et du troisième courant de phase I3.

A intervalles réguliers, le microcontrôleur 6 tente de détecter la coupure frauduleuse d'un ou de plusieurs fils conducteurs f1, f2, f3, qui fausse les mesures d'une ou de plusieurs tensions de phase. Le microcontrôleur 6 détecte une coupure du fil conducteur d'une phase en l'absence de tension et en la présence de courant sur ladite phase.

Pour la première phase Ph1, par exemple, le microcontrôleur 6 détecte une fraude lorsque la première tension de phase est inférieure à un seuil de tension prédéfini alors que le premier courant de phase est supérieur à un seuil de courant prédéfini.

Le microcontrôleur 6 calcule ici $V1_{RMS}$, qui est la valeur efficace de la première tension de phase V1, et $I1_{RMS}$, qui est la valeur efficace du premier courant de phase I1, et détecte une fraude sur la première phase Ph1 lorsque :

$$V1_{RMS} < Vf$$

et

$$I1_{RMS} > If,$$

Vf étant le seuil de tension prédéfini et If étant le seuil de courant prédéfini.

Avantageusement, If est choisi de sorte que :

$$Istart < If < Imin,$$

Istart étant la valeur de courant à partir de laquelle le compteur 1 commence à mesurer l'énergie consommée, et Imin étant la valeur de courant à partir de laquelle le compteur 1 doit mesurer le courant avec la précision nominale.

Ici, on a Istart = 1mA et Imin = 10mA.

On choisit donc par exemple If = 5mA.

On choisit par exemple Vf = 40V.

Cette étape de détection de fraude est réalisée de la même manière pour les deux autres phases.

On suppose maintenant que le microcontrôleur 6 a détecté une fraude sur la première phase Ph1 (uniquement).

Les mesures de la première tension de phase V1 sont donc faussées par la fraude, et les premiers échantillons de tension ne sont pas utilisables.

Le microcontrôleur 6 va donc estimer au moins une première puissance électrique consommée sur la première phase Ph1 en utilisant les mesures de tension sur une phase de référence qui ne subit pas la fraude. Cette phase de référence est ici par exemple la deuxième phase Ph2 (mais aurait aussi pu être la troisième phase Ph3).

Pour cela, le microcontrôleur 6 reconstitue des premiers échantillons de tension estimés $U_{1_n}$, images dans le temps de la première tension de phase V1, à partir de deuxièmes échantillons de tension $V_{2_n}$, images dans le temps de la deuxième tension de phase V2.

La reconstitution est effectuée par périodes de mesure successives, ayant chacune par exemple une durée de 1s.

Chaque tension de phase a une fréquence réseau égale à 50Hz, et donc une période réseau égale à 20ms.

On note N le nombre d'échantillons par période réseau (N est donc le nombre de premiers échantillons de tension par période de la première tension de phase), et $\sigma$ le nombre de périodes réseau par période de mesure. Ici, on a $\sigma$ = 50. On a donc $\sigma N$ échantillons par période de mesure de 1s.

Avantageusement, N est un multiple de 4. Ici, par exemple, N = 52.

La fréquence d'échantillonnage $f_E$ est donc telle que : $f_E$ = 2600Hz.

Le microcontrôleur 6 acquiert tout d'abord un premier décalage d'indice $\Delta 1$ correspondant à un déphasage théorique attendu sans la fraude entre la première tension de phase V1 et la deuxième tension de phase V2. Le premier décalage d'indice a été préenregistré dans la mémoire 7.

Le déphasage théorique attendu est égal à +120°.

Le premier décalage d'indice $\Delta 1$ est un nombre d'échantillons dont il faut décaler les deuxièmes échantillons de tension $V_{2_n}$ pour produire une tension en phase avec la première tension de phase V1, en tenant compte du déphasage théorique attendu, et en considérant qu'un décalage d'indice égal au nombre d'échantillons total par période réseau (soit N) correspondrait à un déphasage de 360°.

On a donc ici :

$$\Delta 1 = 2N/3.$$

Pour chaque premier échantillon de tension estimé $U_{1_n}$, si le premier décalage d'indice $\Delta 1$ est un entier, le microcontrôleur 6 confère audit premier échantillon de tension estimé une valeur d'un deuxième échantillon de tension ayant pour deuxième indice le premier indice n décalé du premier décalage d'indice $\Delta 1$. Sinon, le microcontrôleur 6 confère au premier échantillon de tension estimé $U_{1_n}$ une valeur estimée à partir d'une interpolation utilisant au moins un deuxième échantillon de tension.

Ainsi, si 2N/3 est un entier, le deuxième échantillon de tension $V_{2_{n-2N/3}}$ existe et le microcontrôleur 6 considère que :

$$U_{1_n} = V_{2_{n-2N/3}} .$$

On utilise donc les échantillons déjà connus $V_{2_n}$, mais décalés de 2/3 de période réseau dans le temps.

Par contre, si $\Delta 1$ n'est pas entier, $V_{2_{n-2N/3}}$ n'existe pas, et le microcontrôleur 6 utilise au moins un deuxième échantillon de tension existant pour produire une valeur estimée du premier échantillon de tension estimé $U_{1_n}$.

Ici, le microcontrôleur 6 calcule la valeur estimée en réalisant une interpolation linéaire entre le deuxième échantillon de tension $V_{2_{n\text{-}INT(\Delta 1)\text{-}1}}$ et le deuxième échantillon de tension $V_{2_{n\text{-}INT(\Delta 1)}}$, c'est-à-dire entre $V_{2_{n-INT(\frac{2N}{3})-1}}$ et $V_{2_{n-INT(\frac{2N}{3})}}$.

INT est la fonction « partie entière ».

Le microcontrôleur 6 détermine donc la valeur de l'échantillon $U_{1_n}$ à l'instant précis $n - 2N/3$.

En référence à la figure 2, l'écart de temps entre chaque échantillon est par définition égal à $T_E$ (période d'échantillonnage), soit 384.62ps pour $f_E$ = 2600$Hz$.

Le principe d'interpolation linéaire consiste à faire une estimation de $V_{2_{n-\frac{2N}{3}}}$ correspondant au point de la sinusoïde à l'instant $(n - \frac{2N}{3})$. $T_E$ en approximant au 1er ordre la sinusoïde par la tangente passant par les 2 points $A_1$

$$\left[ \left( n - INT(\tfrac{2N}{3}) - 1 \right).T_E ; V_{2_{n-INT(\frac{2N}{3})-1}} \right] \text{ et } A_2 \left[ n - INT(\tfrac{2N}{3}).T_E ; V_{2_{n-INT(\frac{2N}{3})}} \right].$$

On cherche ainsi à déterminer l'ordonnée du point $A$ de coordonnées $\left[ (n - \tfrac{2N}{3}).T_E ; V_{2_{n-\frac{2N}{3}}} \right]$.

L'équation de la tangente passant par ces deux points est du type $y = a.x + b$ et est très simple à déterminer. On en déduit $V_{2_{n-\frac{2N}{3}}}$ correspondant à l'ordonnée sur la tangente du point A dont l'abscisse $x$ de la tangente est $(n - \tfrac{2N}{3}).T_E$. On montre alors que :

$$V_{2_{n-\frac{2N}{3}}} = V_{2_{n-INT(\frac{2N}{3})}} - \left( V_{2_{n-INT(\frac{2N}{3})}} - V_{2_{n-INT(\frac{2N}{3})-1}} \right) \times (\tfrac{2N}{3} - INT(\tfrac{2N}{3}))$$

Ici, en l'occurrence, 2N/3 n'est pas un entier et l'estimation par interpolation linéaire est réalisée systématiquement pour reconstituer chaque premier échantillon de tension estimé.

Chaque seconde, le microcontrôleur 6 calcule alors une valeur d'au moins une première puissance électrique consommée sur la première phase V1.

La au moins une première puissance électrique calculée par le microcontrôleur 6 comprend ici une première Puissance Active estimée à partir des premiers échantillons de tension estimés $U_{1_n}$ et des premiers échantillons de courant $I_{1_n}$, une première Puissance Réactive estimée à partir d'échantillons d'un niveau sur la fréquence fondamentale de la première tension de phase V1 et d'échantillons d'un niveau sur la fréquence fondamentale du premier courant de phase I1, et une première Puissance Apparente estimée à partir d'une valeur efficace de la première tension de phase V1 et d'une valeur efficace du premier courant de phase I1. Les mesures d'énergie consommée en fonction du temps découlent de ces estimations de puissance.

Ici, le microcontrôleur 6 calcule donc :

$$P_1 = \frac{1}{\sigma.N} \times \sum_{n=0}^{\sigma.N-1} U_{1_n} \times I_{1_n}$$

(première Puissance Active) ;

$$Q_1 = \frac{1}{\sigma.N} \times \sum_{n=0}^{\sigma.N-1} U_{F1_{n-N/4}} \times I_{F1_n}$$

(première Puissance Réactive) ;

$$S_1 = V1_{RMS} . I1_{RMS}$$

(première Puissance Apparente).

$U_{F1_n}$ est le $n^{ième}$ échantillon du niveau sur la fréquence fondamentale de la première tension de phase V1.

$I_{F1_n}$ est le $n^{ième}$ échantillon du niveau sur la fréquence fondamentale du premier courant de phase I1.

Les valeurs $V1_{RMS}$ et $I1_{RMS}$ sont obtenues par calcul à partir des échantillons $U_{1_n}$ et $I_{1_n}$.

On comprend donc l'intérêt que représente le choix d'un nombre d'échantillons N par période réseau multiple de 4, qui permet de faciliter le calcul de la Puissance Réactive par simple décalage d'un quart de période des échantillons du niveau sur la fréquence fondamentale de la première tension de phase V1.

Les échantillons $U_{F1_n}$ du niveau sur la fréquence fondamentale de la première tension de phase V1 et les échantillons $I_{F1_n}$ du niveau sur la fréquence fondamentale du premier courant de phase I1 sont obtenus par un filtrage passe-bas respectivement des premiers échantillons de tension estimés $U_{1_n}$ (reconstitués) et des premiers échantillons de courant $I_{1_n}$.

Le filtrage passe-bas utilise ici un filtre de *Butterworth* du premier ordre.

La transformée en Z d'un filtre de *Butterworth* du premier ordre s'exprime par la relation :

$$H(Z) = \frac{1+Z^{-1}}{1-a.Z^{-1}} \quad \text{avec} \quad Z = e^{\frac{j.2.\pi.f}{f_E}}$$

Avantageusement, on choisit ici :

$$a = 0.7569801925,$$

ce qui permet d'obtenir une fréquence de coupure à 3dB de 70Hz lorsque la fréquence réseau $f_1$ est telle que : $f_1$ = 50Hz.

Il est intéressant de noter qu'à la fréquence réseau $f_1$, sachant que la fréquence d'échantillonnage $f_E$ est telle que $f_E$ = N.$f_1$ (avec ici N = 52), $Z = e^{\frac{j.2.\pi}{N}}$ est indépendant de $f_1$. Ainsi, le gain et le déphasage du filtre à la fréquence $f_1$ est le même $\forall$ $f_1$.

Ce filtre étant linéaire, en notant l'entrée du filtre E(Z) et la sortie du filtre S(Z), on a la relation :

$$S(Z) = H(Z).E(Z)$$

Dans le cas du filtrage numérique des échantillons $U_{1_n}$ en entrée du filtre donnant en sortie les échantillons $U_{F1_n}$, on a donc la relation :

$$U_{F1_n} = U_{1_n} + U_{1_{n-1}} + a.U_{F1_{n-1}}, \quad \text{avec} \quad a = 0.7569801925.$$

On initialise $U_{1_{n-1}}$ et $U_{F1_{n-1}}$ à 0.

De même, pour les autres filtres qui seront décrits plus bas, on a les relations :

$$U_{F_{2n}} = U_{2n} + U_{2n-1} + a.U_{F_{2n-1}}, \text{ avec } a = 0.7569801925.$$

On initialise $U_{2n-1}$ et $U_{F_{2n-1}}$ à 0.

$$U_{F_{3n}} = U_{3n} + U_{3n-1} + a.U_{F_{3n-1}}, \text{ avec } a = 0.7569801925$$

On initialise $U_{3n-1}$ et $U_{F_{3n-1}}$ à 0.

$$I_{F_{1n}} = I_{1n} + I_{1n-1} + a.I_{F_{1n-1}}, \text{ avec } a = 0.7569801925$$

On initialise $I_{1n-1}$ et $I_{F_{1n-1}}$ à 0.

$$I_{F_{2n}} = I_{2n} + I_{2n-1} + a.I_{F_{2n-1}}, \text{ avec } a = 0.7569801925$$

On initialise $I_{2n-1}$ et $I_{F_{2n-1}}$ à 0.

$$I_{F_{3n}} = I_{3n} + I_{3n-1} + a.I_{F_{3n-1}}, \text{ avec } a = 0.7569801925$$

On initialise $I_{3n-1}$ et $I_{F_{3n-1}}$ à 0.

Si la fraude fausse aussi des mesures de la troisième tension de phase V3, présente sur la troisième phase Ph3, la seule phase de référence disponible est la deuxième phase Ph2.

Le microcontrôleur 6 reconstitue donc tout d'abord les premiers échantillons estimés pour la première tension de phase V1, et calcule comme précédemment :

$$P_1 = \frac{1}{\sigma.N} \times \sum_{n=0}^{\sigma.N-1} U_{1_n} \times I_{1_n}$$

(première Puissance Active) ;

$$Q_1 = \frac{1}{\sigma.N} \times \sum_{n=0}^{\sigma.N-1} U_{F1_{n-N/4}} \times I_{F1_n}$$

(première Puissance Réactive) ;

$$S_1 = V1_{RMS} . I1_{RMS}$$

(Puissance Apparente).

Le microcontrôleur 6 utilise ensuite à nouveau les deuxièmes échantillons de tension $V_{2_n}$ pour reconstituer les troisièmes échantillons de tension estimés $U_{3_n}$ et estime au moins une troisième puissance électrique consommée sur la troisième phase Ph3 en utilisant les troisièmes échantillons de tension estimés $U_{3_n}$.

Pour cela, le microcontrôleur 6 acquiert tout d'abord un troisième décalage d'indice Δ3 correspondant à un déphasage théorique attendu sans la fraude entre la troisième tension de phase V3 et la deuxième tension de phase V2.

Le déphasage théorique attendu est égal à -120°.

Le troisième décalage d'indice Δ3 est un nombre d'échantillons dont il faut décaler les deuxièmes échantillons de tension $V_{2_n}$ pour produire une tension en phase avec la troisième tension de phase V3 en tenant compte du déphasage théorique attendu, en considérant qu'un décalage d'indice égal au nombre d'échantillons total par période réseau (soit N) correspondrait à un déphasage de 360°.

On a donc ici :

$$\Delta 3 = N/3.$$

Si le troisième décalage d'indice est un entier, c'est-à-dire si N/3 est un entier, le deuxième échantillon de tension $V_{2_{n-N/3}}$ existe et le microcontrôleur 6 considère que :

$$U_{3_n} = V_{2_{n-N/3}}.$$

Par contre, si $\Delta 3$ n'est pas entier, $V_{2_{n-N/3}}$ n'existe pas, et le microcontrôleur 6 utilise au moins un deuxième échantillon de tension existant pour produire une valeur estimée du troisième échantillon de tension estimé $U_{3_n}$.

Ici, le microcontrôleur 6 calcule la valeur estimée en réalisant une interpolation linéaire entre le deuxième échantillon de tension $V_{2_{n-\text{INT}(\Delta 3)-1}}$ et le deuxième échantillon de tension $V_{2_{n-\text{INT}(\Delta 3)}}$, c'est-à-dire entre $V_{2_{n-\text{INT}(\frac{N}{3})-1}}$ et $V_{2_{n-\text{INT}(\frac{N}{3})}}$.

Le microcontrôleur 6 détermine donc la valeur de l'échantillon $U_{3_n}$ à l'instant précis n - N/3.

Ici, en l'occurrence, N/3 n'est pas un entier et l'estimation par interpolation linéaire est réalisée systématiquement.

Le microcontrôleur 6 calcule alors :

$$P_3 = \frac{1}{\sigma.N} \times \sum_{n=0}^{\sigma.N-1} U_{3_n} \times I_{3_n}$$

(troisième Puissance Active) ;

$$Q_3 = \frac{1}{\sigma.N} \times \sum_{n=0}^{\sigma.N-1} U_{F3_{n-N/4}} \times I_{F3_n}$$

(troisième Puissance Réactive) ;

$$S_3 = V3_{RMS} . I3_{RMS}$$

(troisième Puissance Apparente).

Les échantillons $U_{F3_n}$ et $I_{F3_n}$ sont calculés par application du filtre de *Butterworth* tel que précédemment décrit. Les valeurs $V3_{RMS}$ et $I3_{RMS}$ sont obtenues par calcul à partir des échantillons $U_{3_n}$ et $I_{3_n}$.

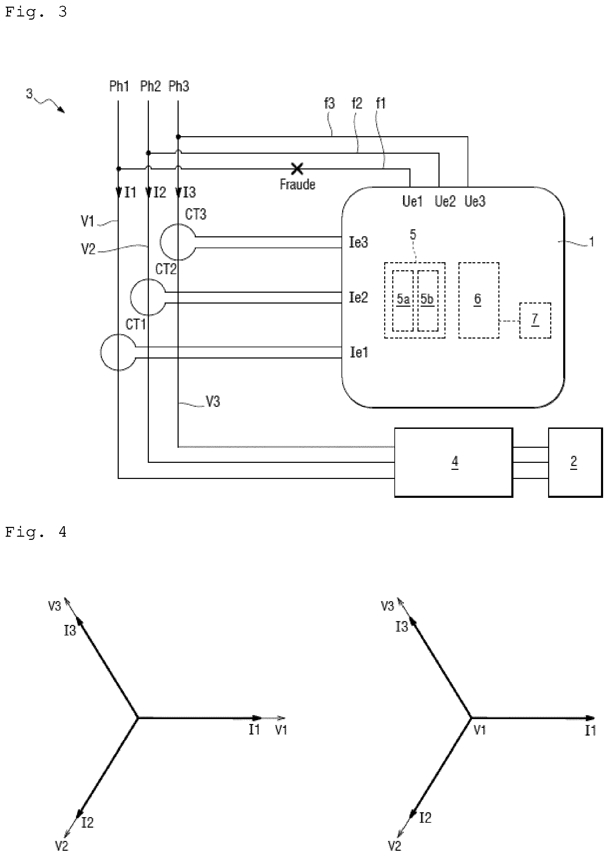

En référence à la figure 3, on se place cette fois dans une configuration à trois fils.

Le réseau de distribution 3 comprend une première phase Ph1, une deuxième phase Ph2 et une troisième phase Ph3, mais pas de neutre.

Le compteur 1 comprend trois entrées de tension Ue1, Ue2, Ue3 et trois entrées de courant Ie1, Ie2, Ie3 (chaque entrée de courant comprenant deux ports).

Le compteur 1 comporte à nouveau des composants de mesure 5 comprenant des composants frontaux 5a et des convertisseurs analogiques numériques 5b, et un microcontrôleur 6 relié aux convertisseurs analogiques numériques 5b.

On se place à nouveau dans une situation où le fil conducteur f1 a été coupé par un utilisateur malintentionné.

On a donc :

$$V1_{RMS} < 40V$$

et

$$I1_{RMS} > 5mA.$$

Le microcontrôleur 6 a donc détecté une fraude qui fausse les mesures de la première tension de phase V1.

On suppose que la fraude ne fausse pas les mesures de la deuxième tension de phase V2 ni de la troisième tension de phase V3.

La mise en oeuvre de l'invention est légèrement différente dans la configuration à trois fils.

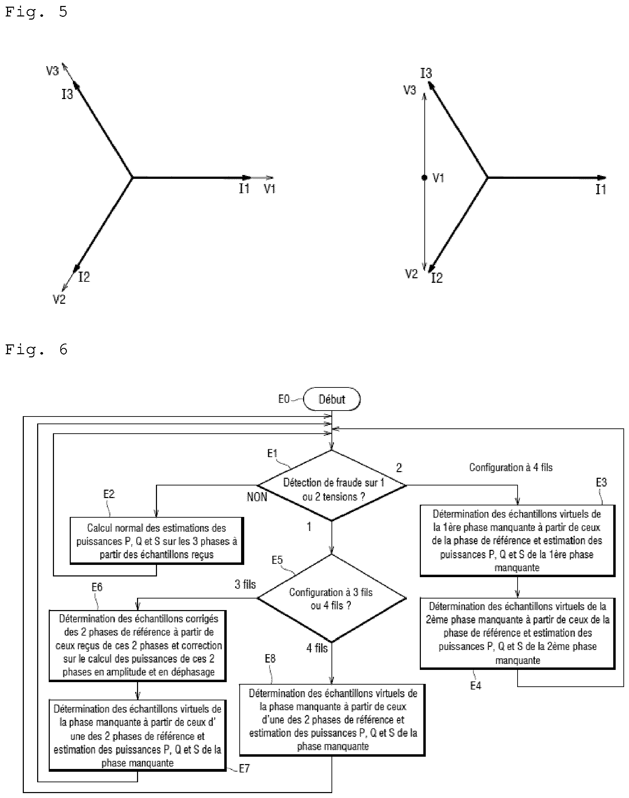

On explique la raison de cette différence à partir des schémas des figures 4 et 5.

La figure 4 représente, dans la configuration à quatre fils de la figure 1, le diagramme de Fresnel des tensions et des courants dans le cas normal (à gauche), et en cas de fraude consistant à couper le fil conducteur f1 (à droite).

On constate que l'absence d'une mesure de tension (mesure de V1 en l'occurrence) n'a aucun impact sur les amplitudes et les angles des autres tensions. En cas d'absence de deux tensions, il en est de même sur la tension restante.

La figure 5 représente, dans la configuration à trois fils de la figure 3, le diagramme de Fresnel des tensions et courants dans la cas normal (à gauche) et en cas de fraude consistant à couper le fil conducteur f1 (à droite).

On constate que l'absence d'une mesure de tension (mesure de V1 en l'occurrence) a un impact sur les amplitudes mesurées (qui sont diminuées d'un rapport $\cos(\pm 30°) = \frac{\sqrt{3}}{2}$ ), mais aussi sur les angles mesurés des autres tensions (+30° sur la mesure de V2 et -30° sur la mesure de V3).

Le microcontrôleur 6 détecte donc tout d'abord, de manière préliminaire, si le réseau de distribution 3 comprend ou non un neutre en plus des trois phases.

Si ce n'est pas le cas, c'est-à-dire si la configuration est une configuration à trois fils, le microcontrôleur 6 tient compte du facteur $\frac{\sqrt{3}}{2}$ et des déphasages de +30° et -30° pour estimer les puissances électriques.

Le microcontrôleur 6 va tout d'abord calculer des deuxièmes échantillons de tension corrigés $U_{2_n}$ et des troisièmes échantillons de tension corrigés $U_{3_n}$.

Le microcontrôleur 6 va alors calculer à partir des deuxièmes échantillons de tension corrigés au moins une deuxième puissance électrique corrigée consommée sur la deuxième phase Ph2 (en l'occurrence, une deuxième Puissance Active, une deuxième Puissance Réactive et une deuxième Puissance Apparente) et, à partir des troisièmes échantillons de tension corrigés, au moins une troisième puissance électrique corrigée consommée sur la troisième phase Ph3 (en l'occurrence, une troisième Puissance Active, une troisième Puissance Réactive et une troisième Puissance Apparente).

Pour calculer les deuxièmes échantillons de tension corrigés $U_{2_n}$, le microcontrôleur 6 acquiert un deuxième décalage d'indice Δ2 correspondant à un déphasage théorique attendu pour les mesures de la deuxième tension de phase V2 du fait de la fraude.

Pour la deuxième phase, le déphasage théorique est égal à 30°, et donc le deuxième décalage d'indice Δ2 est tel que :

$$\Delta 2 = 11N/12.$$

Le microcontrôleur 6 multiplie tout d'abord les deuxièmes échantillons de tension $V_{2_n}$ par un facteur prédéterminé, ici égal à $\frac{2}{\sqrt{3}}$ , ce qui permet de compenser l'amplitude qui a été réduite du facteur inverse. On obtient des deuxièmes échantillons résultants.

Pour chaque deuxième échantillon de tension corrigé $U_{2_n}$, associé à un deuxième indice corrigé, si le deuxième décalage d'indice est un entier, le microcontrôleur 6 confère au deuxième échantillon de tension corrigé $U_{2_n}$ la valeur d'un deuxième échantillon de tension résultant ayant pour deuxième indice le deuxième indice corrigé décalé du deuxième décalage d'indice. Sinon, le microcontrôleur 6 confère au deuxième échantillon de tension corrigé $U_{2_n}$ une valeur estimée à partir d'une interpolation utilisant au moins un deuxième échantillon de tension résultant.

Le décalage temporel « idéal », permettant d'obtenir les deuxièmes échantillons corrigés sans calculer d'interpolation linéaire, correspond donc à l'instant précis $n$ - 11N/12 dans le cas des deuxièmes échantillons de tension.

N doit donc être divisible par 12, ce qui n'est pas le cas ici avec N = 52, de sorte que les interpolations linéaires sont calculées systématiquement.

De même, pour calculer les troisièmes échantillons de tension corrigés $U_{3_n}$, le microcontrôleur 6 acquiert un troisième décalage d'indice correspondant à un déphasage théorique attendu pour les mesures de la troisième tension de phase V3 du fait de la fraude.

Pour la troisième phase, le déphasage théorique est égal à -30°, donc le troisième décalage d'indice Δ3 est tel que :

$$\Delta 3 = N/12.$$

Le microcontrôleur 6 multiplie tout d'abord les troisièmes échantillons de tension $V_{3_n}$ par un facteur prédéterminé, ici égal à $\dfrac{2}{\sqrt{3}}$ , ce qui permet de compenser l'amplitude qui a été réduite du facteur inverse. On obtient des troisièmes échantillons résultants.

Pour chaque troisième échantillon corrigé $U_{3_n}$ associé à un troisième indice corrigé, si le troisième décalage d'indice est un entier, le microcontrôleur 6 confère au troisième échantillon de tension corrigé $U_{3_n}$ la valeur d'un troisième échantillon de tension résultant ayant pour troisième indice le troisième indice corrigé décalé du troisième décalage d'indice. Sinon, le microcontrôleur 6 confère au troisième échantillon de tension corrigé une valeur estimée à partir d'une interpolation utilisant au moins un troisième échantillon de tension résultant.

Le décalage temporel « idéal », permettant d'obtenir les troisièmes échantillons corrigés sans calculer d'interpolation linéaire, correspond donc à l'instant précis $n - N/12$ dans le cas des troisièmes échantillons de tension.

N doit donc être divisible par 12, ce qui n'est pas le cas ici avec N = 52, de sorte que les interpolations linéaires sont calculées systématiquement.

Le microcontrôleur 6 calcule ensuite les deuxièmes puissances électriques corrigées consommées sur la deuxième phase Ph2 et les troisièmes puissances électriques corrigées consommées sur la troisième phase Ph3 :

$$P_2 = \frac{1}{\sigma.N} \times \sum_{n=0}^{\sigma.N-1} U_{2_n} \times I_{2_n}$$

(deuxième Puissance Active corrigée) ;

$$Q_2 = \frac{1}{\sigma.N} \times \sum_{n=0}^{\sigma.N-1} U_{F2_{n-N/4}} \times I_{F2_n}$$

(deuxième Puissance Réactive corrigée) ;

$$S_2 = U2_{RMS} \cdot I2_{RMS}$$

(deuxième Puissance Apparente corrigée) ;

$$P_3 = \frac{1}{\sigma.N} \times \sum_{n=0}^{\sigma.N-1} U_{3_n} \times I_{3_n}$$

(troisième Puissance Active corrigée) ;

$$Q_3 = \frac{1}{\sigma.N} \times \sum_{n=0}^{\sigma.N-1} U_{F3_{n-N/4}} \times I_{F3_n}$$

(troisième Puissance Réactive corrigée) ;

$$S_3 = U3_{RMS} \cdot I3_{RMS}$$

(troisième Puissance Apparente corrigée).

Les échantillons $U_{F2_n}$ et $I_{F2_n}$ sont calculés par application du filtre de *Butterworth* précédemment décrit, respectivement sur les deuxièmes échantillons de tension corrigés $U_{2_n}$ et sur les deuxièmes échantillons de courant $I_{2_n}$.

De même, les échantillons $U_{F3_n}$ et $I_{F3_n}$ sont calculés par application du filtre de *Butterworth* précédemment décrit, respectivement sur les troisièmes échantillons de tension corrigés $U_{3_n}$ et sur les troisièmes échantillons de courant $I_{3_n}$.

Les premiers échantillons de tension estimés $U_{1_n}$ sont alors reconstitués en appliquant exactement la même méthode que dans la configuration à quatre fils, sur l'ensemble d'une période de 1s. Cette fois, cependant, ce sont les deuxièmes échantillons de tension corrigés $U_{2_n}$ qui sont utilisés.

Le microcontrôleur 6 calcule alors les premières puissances électriques consommées sur la première phase Ph1 de la manière suivante :

$$P_1 = \frac{1}{\sigma.N} \times \sum_{n=0}^{\sigma.N-1} U_{1_n} \times I_{1_n}$$

(première Puissance Active) ;

$$Q_1 = \frac{1}{\sigma.N} \times \sum_{n=0}^{\sigma.N-1} U_{F1_{n-N/4}} \times I_{F1_n}$$

(première Puissance Réactive) ;

$$S_1 = V1_{RMS} \cdot I1_{RMS}$$

(première Puissance Apparente).

Les échantillons $U_{F1_n}$ et $I_{F1_n}$ sont calculés par application du filtre de Butterworth précédemment décrit, respectivement sur les premiers échantillons de tension estimés $U_{1_n}$ et sur les premiers échantillons de courant $I_{1_n}$.

Comme on l'a vu, le microcontrôleur 6 doit détecter si la configuration est une configuration à quatre fils ou à trois fils, c'est-à-dire si le réseau de distribution 3 comprend ou non un neutre en plus des trois phases. L'estimation des premières puissances électriques diffère en effet selon la configuration effective. De même, l'application de la correction sur les deuxièmes puissances électriques et sur les troisièmes puissances électriques dépend de la configuration.

Le procédé d'estimation de puissance comprend donc une étape préliminaire consistant à détecter si le réseau 3 et le compteur 1 se trouvent dans une configuration à quatre fils ou à trois fils.

Pour cela, après avoir détecté une fraude sur la première phase Ph1, le microcontrôleur 6 mesure l'angle φ entre les deux tensions restantes, c'est-à-dire entre la deuxième tension de phase V2 et la troisième tension de phase V3 (dans le cas où les mesures de la deuxième tension de phase V2 et les mesures de la troisième tension de phase V3 ne sont pas faussées).

Le microcontrôleur 6 détermine alors si l'angle φ est en valeur absolue proche de 180° et, si c'est le cas, détecte une configuration à trois fils.

Le microcontrôleur 6 vérifie si l'angle φ appartient ou non à l'intervalle prédéfini :

$$180° - X° < |\varphi| < 180° + X°.$$

X est une valeur prédéfinie positive et inférieure à 30. On a par exemple X = 20.

Si l'angle φ appartient à l'intervalle prédéfini, le microcontrôleur 6 considère que l'angle φ est en valeur absolue proche de 180° et donc détecte une configuration à trois fils. Sinon, le microcontrôleur 6 détecte une configuration à quatre fils.

On note que, dans la configuration à trois fils, il est possible d'estimer les puissances qui auraient dû être consommées en l'absence de fraude seulement si une seule des entrées de tension est manquante (fraude sur une seule phase, car en 3 fils, si deux phases sont manquantes, le compteur n'est plus alimenté), alors que dans la configuration à quatre fils, il est possible de les estimer même dans le cas de deux entrées de tension manquantes.

On note aussi qu'il est possible que, dans le cas où le microcontrôleur 6 détecte que deux entrées de tension sont manquantes (fraude sur deux phases), le microcontrôleur 6 détecte systématiquement la configuration à quatre fils (puisque le compteur 1 est alimenté) ; le compteur 1 met alors en oeuvre le procédé d'estimation dans les conditions correspondantes. En effet, les compteurs s'éteignent automatiquement lorsque la configuration est une configuration à trois fils et que deux tensions sont manquantes.

Les différentes étapes du procédé d'estimation sont visibles sur la figure 6.

Le procédé débute à l'étape E0.

Le microcontrôleur 6 tente de détecter au moins une fraude sur l'une des trois phases (étape E1).

Si aucune fraude n'est détectée, le microcontrôleur 6 calcule normalement les estimations de la Puissance Active, de la Puissance Réactive et de la Puissance Apparente pour chacune des trois phases, en utilisant les échantillons de tension et les échantillons de courant transmis par les convertisseurs analogiques numériques 5b (étape E2). Aucune reconstruction d'échantillon de tension n'est nécessaire.

Le calcul des estimations de puissances est réalisé à intervalles réguliers (cycle de 1s par exemple).

Le procédé retourne à l'étape E1.

A l'étape E1, si le microcontrôleur 6 détecte une fraude sur deux phases, le microcontrôleur 6 en déduit directement que la configuration est une configuration à quatre fils (voir ce qui vient d'être expliqué).

On suppose par exemple que les mesures de la première tension de phase V1 et les mesures de la troisième tension de phase V3 sont faussées.

Le microcontrôleur 6 reconstitue tout d'abord les premiers échantillons de tension estimés à partir des deuxièmes échantillons de tension images de la deuxième tension de phase (tension de référence). Le microcontrôleur 6 estime alors les premières puissances électriques consommées sur la première phase (étape E3).

Puis, le microcontrôleur 6 reconstitue les troisièmes échantillons de tension estimés à partir des deuxièmes échantillons de tension images de la deuxième tension de phase (tension de référence). Le microcontrôleur 6 estime alors les troisièmes puissances électriques consommées sur la troisième phase (étape E4).

Le calcul des estimations de puissances est réalisé à intervalles réguliers (cycle de 1s par exemple).

Le procédé retourne à l'étape E1.

On suppose maintenant qu'à l'étape E1, le microcontrôleur 6 détecte une fraude sur une seule phase ; on suppose que les mesures de la première tension de phase sont faussées.

Le microcontrôleur 6 détecte alors si le réseau 3 et le compteur 1 se trouvent dans une configuration à quatre fils ou à trois fils (étape E5).

Si la configuration à trois fils est détectée, le microcontrôleur 6 produit des deuxièmes échantillons de tension corrigés pour la deuxième phase Ph2 (correction en amplitude et en phase), et utilise les deuxièmes échantillons de tension corrigés pour calculer les deuxièmes puissances électriques corrigées consommées sur la deuxième phase Ph2. De même, le microcontrôleur 6 produit des troisièmes échantillons de tension corrigés pour la troisième phase Ph3, et utilise les troisièmes échantillons de tension corrigés pour calculer les troisièmes puissances électriques corrigées consommées sur la troisième phase Ph3 : étape E6.

Le microcontrôleur 6 reconstitue ensuite les premiers échantillons de tension estimés à partir des deuxièmes échantillons de tension corrigés (ou des troisièmes échantillons de tension corrigés), et estime alors les premières puissances électriques consommées sur la première phase (étape E7).

Le calcul des estimations de puissances est réalisé à intervalles réguliers (cycle de 1s par exemple).

Le procédé retourne à l'étape E1.

A l'étape E5, si la configuration à quatre fils est détectée, le microcontrôleur 6 reconstitue les premiers échantillons de tension estimés à partir des deuxièmes échantillons de tension (ou des troisièmes échantillons de tension), et estime alors les premières puissances électriques consommées sur la première phase (étape E8).

Le calcul des estimations de puissances est réalisé à intervalles réguliers (cycle de 1s par exemple).

Le procédé retourne à l'étape E1.

On décrit maintenant le procédé d'estimation de puissance selon un deuxième mode de réalisation de l'invention.

On considère à nouveau que la fraude fausse les mesures de la première tension de phase V1 présente sur la première phase Ph1, sans fausser les mesures de la deuxième tension de phase V2 présente sur la deuxième phase Ph2. La deuxième tension de phase V2 est à nouveau la tension de référence.

La principale différence entre le deuxième mode de réalisation et le premier mode de réalisation concerne l'étape de reconstitution, qui est mise en oeuvre pour reconstituer les premiers échantillons de tension estimés.

Une table de référence a été préenregistrée dans la mémoire 7. Cette table de référence contient des échantillons de référence d'une fonction sinusoïdale, en l'occurrence de la fonction cosinus.

Chaque échantillon de référence s'écrit $\cos(\theta_i)$, et a donc pour valeur la valeur du cosinus (axe des ordonnées) en fonction de l'angle $\theta_i$ (axe des abscisses).

On a $\cos(\theta_0) = 1$.

La valeur de i correspond à la position dans la table de la valeur $\cos(\theta_i)$. La valeur de i est aussi l'indice de l'échantillon de référence $\cos(\theta_i)$.

Le pas des angles $\theta_i$ est par exemple égal à 0,1° (c'est-à-dire que pour tout i, $\theta_{i+1} - \theta_i = 0,1°$).

On note qu'il est suffisant que la table de référence contienne des échantillons de référence pour i variant de 0° à 90°. Les valeurs sur ¼ de période suffisent en effet pour reconstituer toute la période par symétrie horizontale selon l'axe des abscisses et verticale selon l'axe des ordonnées.

Pour reconstituer les premiers échantillons de tension estimés, le microcontrôleur 6 acquiert tout d'abord la table de référence.

Le microcontrôleur 6 mesure alors une valeur maximale de la deuxième tension de phase V2 et multiplie les échantillons de référence par un facteur d'amplitude proportionnel à la valeur maximale pour obtenir des échantillons de référence résultants.

Ici, le facteur d'amplitude est égal à la valeur maximale $V2_{max}$, qui est telle que :

$$V2_{max} = \sqrt{2}.V2_{RMS},$$

dans la configuration à 4 fils, et

$$V2_{max} = \frac{2.\sqrt{2}}{\sqrt{3}}.V2_{RMS}$$

dans la configuration à 3 fils.

Puis, pour chaque premier échantillon de tension estimé associé à un premier indice, le microcontrôleur 6 confère audit premier échantillon de tension estimé la valeur d'un échantillon de référence résultant ayant pour indice le premier indice décalé d'un décalage d'indice correspondant à un déphasage théorique attendu sans la fraude entre la première tension de phase et la deuxième tension de phase.

Le microcontrôleur 6 décale donc les échantillons de référence, contenus dans la table de référence, de ±120° (±0.1°).

Cette méthode permet d'éviter tout calcul et économise de manière drastique le temps CPU.

Le microcontrôleur 6 estime alors les premières puissances électriques consommées sur la première phase en utilisant les premiers échantillons de tension estimés.

En variante, et quelle que soit la configuration (quatre fils ou trois fils), dans le cas où la fraude touche uniquement la première phase Ph1, il est possible, pour estimer les premières puissances électriques, de reconstituer les premiers échantillons de tension estimés à partir à la fois des deuxièmes échantillons de tension (deuxième tension de phase V2) et des troisièmes échantillons de tension (troisième tension de phase V3).

Le microcontrôleur 6 calcule pour cela une moyenne arithmétique des premiers échantillons de tension estimés, reconstitués à partir des deuxièmes échantillons de tension, et des premiers échantillons de tension estimés, reconstitués à partir des troisièmes échantillons de tension, pour produire des premiers échantillons de tension consolidés, qui sont utilisés pour estimer les premières puissances électriques.

Bien entendu, l'invention n'est pas limitée aux modes de réalisation décrits mais englobe toute variante entrant dans le champ de l'invention telle que définie par les revendications.

On a indiqué que le déphasage théorique attendu sans la fraude, entre la première tension de phase et la deuxième tension de phase, est égal à +120°. Bien sûr, cette valeur dépend des phases qui sont appelées « première phase » et « deuxième phase » ; le déphasage théorique attendu pourrait être égal à -120°. Le premier décalage d'indice Δ1 pourrait donc être tel que :

$$\Delta1 = N/3$$

De même, le déphasage théorique attendu pour les mesures de la deuxième tension de phase du fait de la fraude pourrait être égal à -30°, et le déphasage théorique attendu pour les mesures de la troisième tension de phase du fait de la fraude pourrait être égal à +30°.

L'architecture du compteur pourrait être différente de celle décrite ici. Le ou les convertisseurs analogiques numériques pourraient ainsi par exemple être intégrés dans le microcontrôleur.

**Revendications**

1. Procédé d'estimation de puissance, mis en oeuvre dans un compteur électrique triphasé (1), et comprenant les étapes de :

    - détecter une fraude qui fausse des mesures d'une première tension de phase (V1) présente sur une première phase (Ph1) d'un réseau de distribution (3), sans fausser de mesures d'une deuxième tension de phase (V2) présente sur une deuxième phase (Ph2) du réseau de distribution (3) ;
    - reconstituer des premiers échantillons de tension estimés, images dans le temps de la première tension de phase (V1), à partir de deuxièmes échantillons de tension, images dans le temps de la deuxième tension de phase (V2), les deuxièmes échantillons de tension étant décalés dans le temps d'un déphasage théorique attendu sans la fraude entre la première tension de phase et la deuxième tension de phase ;
    - estimer au moins une première puissance électrique consommée sur la première phase en utilisant les premiers échantillons de tension estimés.

**2.** Procédé d'estimation de puissance selon la revendication 1, dans lequel la reconstitution comprend les étapes d'acquérir un premier décalage d'indice correspondant au déphasage théorique attendu et, pour chaque premier échantillon de tension estimé associé à un premier indice :

- si le premier décalage d'indice est un entier, de conférer au premier échantillon de tension estimé une valeur d'un deuxième échantillon de tension ayant pour deuxième indice le premier indice décalé du premier décalage d'indice ;
- sinon, de conférer au premier échantillon de tension estimé une valeur estimée obtenue à partir d'une interpolation utilisant au moins un deuxième échantillon de tension.

**3.** Procédé d'estimation de puissance selon la revendication 2, dans lequel le premier décalage d'indice $\Delta 1$ est tel que :

$$\Delta 1 = 2N/3 \text{ ou } \Delta 1 = N/3,$$

où N est un nombre de premiers échantillons de tension par période de la première tension de phase,
et dans lequel, si $\Delta 1$ est un entier, on a :

$$U_{1_n} = V_{2_{n-\Delta 1}}.$$

**4.** Procédé d'estimation de puissance selon la revendication 3, comprenant l'étape, si $\Delta 1$ n'est pas un entier, de calculer la valeur estimée en réalisant une interpolation linéaire entre le deuxième échantillon de tension $V_{2n-INT(\Delta 1)-1}$ et le deuxième échantillon de tension $V_{2n-INT(\Delta 1)}$, INT étant la fonction partie entière.

**5.** Procédé d'estimation de puissance selon la revendication 1, dans lequel la reconstitution comprend les étapes de :

- acquérir une table de référence préenregistrée et contenant des échantillons de référence d'un signal sinusoïdal ;
- mesurer une valeur maximale de la deuxième tension de phase et multiplier les échantillons de référence par un facteur d'amplitude proportionnel à la valeur maximale pour obtenir des échantillons de référence résultants, et

pour chaque premier échantillon de tension estimé associé à un premier indice, conférer au premier échantillon de tension estimé une valeur d'un échantillon de référence résultant ayant pour indice le premier indice décalé d'un décalage d'indice correspondant au déphasage théorique attendu sans la fraude entre la première tension de phase et la deuxième tension de phase.

**6.** Procédé d'estimation de puissance selon l'une des revendications précédentes, dans lequel la au moins une première puissance électrique comprend une première Puissance Active estimée à partir des premiers échantillons de tension estimés et de premiers échantillons de courant, images dans le temps d'un premier courant de phase (I1) circulant sur la première phase, et/ou une première Puissance Réactive estimée à partir d'échantillons d'un niveau sur une fréquence fondamentale de la première tension de phase (V1) et d'échantillons d'un niveau sur une fréquence fondamentale du premier courant de phase (I1), et/ou une première Puissance Apparente estimée à partir d'une valeur efficace de la première tension de phase (V1) et d'une valeur efficace du premier courant de phase (I1).

**7.** Procédé d'estimation de puissance selon la revendication 6, dans lequel les échantillons du niveau sur la fréquence fondamentale de la première tension de phase (V1) et les échantillons du niveau sur la fréquence fondamentale du premier courant de phase (I1) sont obtenus par application d'un filtre passe-bas respectivement sur les premiers échantillons de tension estimés et sur les premiers échantillons de courant.

**8.** Procédé d'estimation de puissance selon la revendication 7, dans lequel le filtrage passe-bas est un filtre de *Butterworth* du premier ordre ayant une transformée en Z *H(Z)* telle que :

$$H(Z) = \frac{1+Z^{-1}}{1-a.Z^{-1}},$$

avec :

$$a = 0.7569801925\,.$$

**9.** Procédé d'estimation de puissance selon l'une des revendications précédentes, comprenant en outre les étapes, si la fraude fausse aussi des mesures d'une troisième tension de phase (V3), présente sur une troisième phase (Ph3), d'utiliser à nouveau les deuxièmes échantillons de tension pour reconstituer des troisièmes échantillons de tension estimés, images dans le temps de la troisième tension de phase, et d'estimer au moins une troisième puissance électrique consommée sur la troisième phase en utilisant les troisièmes échantillons de tension estimés.

**10.** Procédé d'estimation de puissance selon l'une des revendications précédentes, comprenant en outre les étapes de détecter si le réseau de distribution (3) comprend ou non un neutre (N) en plus des trois phases et, si ce n'est pas le cas,
de calculer des deuxièmes échantillons de tension corrigés, et de calculer au moins une deuxième puissance électrique corrigée consommée sur la deuxième phase (Ph2) à partir des deuxièmes échantillons de tension corrigés.

**11.** Procédé d'estimation de puissance selon la revendication 10, dans lequel le calcul des deuxièmes échantillons de tension corrigés comprend les étapes d'acquérir un deuxième décalage d'indice correspondant à un déphasage théorique attendu pour les mesures de la deuxième tension de phase (V2) du fait de la fraude, de multiplier les deuxièmes échantillons de tension par un facteur prédéterminé pour obtenir des deuxièmes échantillons résultants et, pour chaque deuxième échantillon de tension corrigé associé à un deuxième indice corrigé :

- si le deuxième décalage d'indice est un entier, de conférer au deuxième échantillon de tension corrigé une valeur d'un deuxième échantillon de tension résultant ayant pour deuxième indice le deuxième indice corrigé décalé du deuxième décalage d'indice ;
- sinon, conférer au deuxième échantillon de tension corrigé une valeur estimée obtenue à partir d'une interpolation utilisant au moins un deuxième échantillon de tension résultant.

**12.** Procédé d'estimation de puissance selon la revendication 10, dans lequel une absence de neutre (N) est détectée lorsqu'un angle φ entre la deuxième tension de phase (V2) et la troisième tension de phase (V3) est tel que :

$$180° - X° < |\varphi| < 180° + X°,$$

X étant une valeur prédéfinie positive et inférieure à 30.

**13.** Procédé d'estimation de puissance selon l'une des revendications précédentes, dans lequel la fraude est détectée lorsque la première tension de phase est inférieure à un seuil de tension prédéfini alors que le premier courant de phase est supérieur à un seuil de courant prédéfini.

**14.** Compteur électrique triphasé, comprenant un composant de traitement (6) agencé pour mettre en oeuvre le procédé d'estimation de puissance selon l'une des revendications précédentes.

**15.** Programme d'ordinateur comprenant des instructions qui conduisent le composant de traitement (6) du compteur électrique triphasé (1) selon la revendication 14 à exécuter les étapes du procédé d'estimation de puissance selon l'une des revendications 1 à 13.

**16.** Support d'enregistrement lisible par ordinateur, sur lequel est enregistré le programme d'ordinateur selon la revendication 15.

**Patentansprüche**

**1.** Leistungsschätzungsverfahren, das in einem dreiphasigen Stromzähler (1) durchgeführt wird und die Schritte umfasst:

- Detektieren eines Betrugs, der Messungen einer ersten Phasenspannung (V1), die auf einer ersten Phase (Ph1) eines Verteilungsnetzes (3) vorhanden ist, verfälscht, ohne Messungen einer zweiten Phasenspannung (V2), die auf einer zweiten Phase (Ph2) des Verteilungsnetzes (3) vorhanden ist, zu verfälschen;
- Rekonstruieren von ersten geschätzten Spannungsproben, Bilder über die Zeit der ersten Phasenspannung (V1), anhand von zweiten Spannungsproben, Bilder über die Zeit der zweiten Phasenspannung (V2), wobei die zweiten Spannungsproben über die Zeit um eine erwartete theoretische Phasenverschiebung ohne Betrug zwischen der ersten Phasenspannung und der zweiten Phasenspannung versetzt sind;
- Schätzen mindestens einer ersten elektrischen Leistung, die auf der ersten Phase verbraucht wird, indem die ersten geschätzten Spannungsproben verwendet werden.

2. Leistungsschätzungsverfahren nach Anspruch 1, bei dem die Rekonstruktion die Schritte umfasst: Erfassen eines ersten Indexversatzes, der der erwarteten theoretischen Phasenverschiebung entspricht, und für jede erste geschätzte Spannungsprobe, die mit einem ersten Index verbunden ist:

- sofern der erste Indexversatz eine ganze Zahl ist, Zuweisen zur ersten geschätzten Spannungsprobe eines Werts einer zweiten Spannungsprobe, die als zweiten Index den ersten Index versetzt um den ersten Indexversatz hat;
- andernfalls, Zuweisen zur ersten geschätzten Spannungsprobe eines geschätzten Werts, der anhand einer Interpolation erhalten wird, die mindestens eine zweite Spannungsprobe verwendet.

3. Leistungsschätzungsverfahren nach Anspruch 2, bei dem der erste Indexversatz $\Delta 1$ derart ist, dass:

$$\Delta 1 = 2N/3 \text{ oder } \Delta 1 = N/3,$$

wobei N eine Anzahl von ersten Spannungsproben pro Periode der ersten Phasenspannung ist, und bei dem, sofern $\Delta 1$ eine ganze Zahl ist, gilt:

$$U_{1_n} = V_{2_{n-\Delta 1}}.$$

4. Leistungsschätzungsverfahren nach Anspruch 3, umfassend den Schritt, sofern $\Delta 1$ keine ganze Zahl ist, des Berechnens des geschätzten Werts, indem eine lineare Interpolation zwischen der zweiten Spannungsprobe $V_{2n-INT(\Delta 1)-1}$ und der zweiten Spannungsprobe $V_{2n-INT(\Delta 1)}$ durchgeführt wird, wobei INT die Ganzzahl-Teilfunktion ist.

5. Leistungsschätzungsverfahren nach Anspruch 1, bei dem die Rekonstruktion die Schritte umfasst:

- Erfassen einer Referenztabelle, die vorgespeichert ist und Referenzproben eines Sinussignals enthält;
- Messen eines maximalen Werts der zweiten Phasenspannung und Multiplizieren der Referenzproben mit einem Amplitudenfaktor, der proportional zu dem maximalen Wert ist, um resultierende Referenzproben zu erhalten, und

für jede erste geschätzte Spannungsprobe, die mit einem ersten Index verbunden ist, Zuweisen zur ersten geschätzten Spannungsprobe eines Werts einer resultierenden Referenzprobe, die als Index den ersten Index versetzt um einen Indexversatz hat, der der erwarteten theoretischen Phasenverschiebung ohne Betrug zwischen der ersten Phasenspannung und der zweiten Phasenspannung entspricht.

6. Leistungsschätzungsverfahren nach einem der vorhergehenden Ansprüche, bei dem die mindestens eine erste elektrische Leistung eine erste Wirkleistung umfasst, die anhand der ersten geschätzten Spannungsproben und von ersten Stromproben geschätzt wird, Bilder über die Zeit eines ersten Phasenstroms (I1), der auf der ersten Phase fließt, und/oder eine Blindleistung, die anhand von Proben eines Pegels auf einer Grundfrequenz der ersten Phasenspannung (V1) und von Proben eines Pegels auf einer Grundfrequenz des ersten Phasenstroms (I1) geschätzt wird, und/oder eine erste Scheinleistung, die anhand eines effektiven Werts der ersten Phasenspannung (V1) und eines effektiven Werts des ersten Phasenstroms (I1) geschätzt wird.

7. Leistungsschätzungsverfahren nach Anspruch 6, bei dem die Proben des Pegels auf der Grundfrequenz der ersten Phasenspannung (V1) und die Proben des Pegels auf der Grundfrequenz des ersten Phasenstroms (I1) durch Anwendung eines Tiefpassfilters an den ersten geschätzten Spannungsproben bzw. den ersten Stromproben erhalten werden.

8. Leistungsschätzungsverfahren nach Anspruch 7, bei dem die Tiefpassfilterung ein Butterworth-Filter der ersten Ordnung ist, der eine Z-Transformierte $H(Z)$ hat, derart, dass

$$H(Z) = \frac{1+Z^{-1}}{1-a.Z^{-1}},$$

wobei:

a = 0,7569801925.

9. Leistungsschätzungsverfahren nach einem der vorhergehenden Ansprüche, ferner umfassend die Schritte, sofern der Betrug auch Messungen einer dritten Phasenspannung (V3) verfälscht, die auf einer dritten Phase (Ph3) vorhanden ist, des erneuten Verwendens der zweiten Spannungsproben, um dritte geschätzte Spannungsproben zu rekonstruieren, Bilder über die Zeit der dritten Phasenspannung, und des Schätzens mindestens einer dritten elektrischen Leistung, die auf der dritten Phase verbraucht wird, indem die dritten geschätzten Spannungsproben verwendet werden.

10. Leitungsschätzungsverfahren nach einem der vorhergehenden Ansprüche, ferner umfassend die Schritte des Detektierens, ob das Verteilungsnetz (3) einen Neutralleiter (N) zusätzlich zu den drei Phasen umfasst oder nicht, und, wenn dies nicht der Fall ist,
des Berechnens von zweiten korrigierten Spannungsproben, und des Berechnens mindestens einer zweiten korrigierten elektrischen Leistung, die auf der zweiten Phase (Ph2) verbraucht wird, anhand der zweiten korrigierten Spannungsproben.

11. Leistungsschätzungsverfahren nach Anspruch 10, bei dem die Berechnung der zweiten korrigierten Spannungsproben die Schritte umfasst: Erfassen eines zweiten Indexversatzes, der einer erwarteten theoretischen Phasenverschiebung für die Messungen der zweiten Phasenspannung (V2) aufgrund des Betrugs entspricht, Multiplizieren der zweiten Spannungsproben mit einem vorbestimmten Faktor zum Erhalten von zweiten resultierenden Proben und, für jede zweite korrigierte Spannungsprobe, die mit einem zweiten korrigierten Index verbunden ist:

   - sofern der zweite Indexversatz eine ganze Zahl ist, Zuweisen zur zweiten korrigierten Spannungsprobe eines Wert einer zweiten resultierenden Spannungsprobe, die als zweiten Index den zweiten korrigierten Index versetzt um den zweiten Indexversatz hat;
   - andernfalls, Zuweisen zur zweiten korrigierten Spannungsprobe eines geschätzten Werts, der anhand einer Interpolation erhalten wird, die mindestens eine zweite resultierende Spannungsprobe verwendet.

12. Leistungsschätzungsverfahren nach Anspruch 10, bei dem ein Nichtvorhandensein eines Neutralleiters (N) detektiert wird, wenn ein Winkel φ zwischen der zweiten Phasenspannung (V2) und der dritten Phasenspannung (V3) derart ist, dass:

180° - X° < │φ│ < 180° + X°,

wobei X ein vordefinierter positiver Wert und kleiner als 30 ist.

13. Leistungsschätzungsverfahren nach einem der vorhergehenden Ansprüche, bei dem der Betrug detektiert wird, wenn die erste Phasenspannung niedriger als ein vordefinierter Spannungsschwellenwert ist, während der erste Phasenstrom größer als ein vordefinierter Stromschwellenwert ist.

14. Dreiphasiger Stromzähler, umfassend eine Verarbeitungskomponente (6), die ausgebildet ist, das Leistungsschätzungsverfahren nach einem der vorhergehenden Ansprüche durchzuführen.

15. Computerprogramm, umfassend Anweisungen, die die Verarbeitungskomponente (6) des dreiphasigen Stromzählers (1) nach Anspruch 14 dazu veranlassen, die Schritte des Leistungsschätzungsverfahrens nach einem der Ansprüche 1 bis 13 auszuführen.

**16.** Computerlesbarer Aufzeichnungsträger, auf dem das Computerprogramm nach Anspruch 15 gespeichert ist.


**Claims**

**1.** Power estimation method, implemented in a three-phase electricity meter (1), and comprising the steps of:

detecting a fraud which falsifies measurements of a first phase voltage (V1) present on a first phase (Ph1) of a distribution network (3), without falsifying measurements of a second phase voltage (V2) present on a second phase (Ph2) of the distribution network (3);
reconstituting first estimated voltage samples, images over time of the first phase voltage (V1), from second voltage samples, images over time of the second phase voltage (V2), the second voltage samples being offset over time by an expected theoretical phase shift without fraud between the first phase voltage and the second phase voltage;
estimating at least one first electrical power consumed on the first phase by using the first estimated voltage samples.

**2.** Power estimation method according to claim 1, wherein the reconstitution comprises the steps of acquiring a first index offset corresponding to the expected theoretical phase shift and, for each first estimated voltage sample associated with a first index:

if the first index offset is an integer, of conferring to the first estimated voltage sample, a value of a second voltage sample having as a second index, the first index offset from the first index offset;
otherwise, of conferring to the first estimated voltage sample, an estimated value obtained from an interpolation using at least one second voltage sample.

**3.** Power estimation method according to claim 2, wherein the first index offset $\Delta 1$ is such that:

$$\Delta 1 = 2N/3 \ \text{or} \ \Delta 1 = N/3,$$

where N is a number of first voltage samples per period of the first phase voltage,
and in which, if $\Delta 1$ is an integer, the following occurs:

$$U_{1_n} = V_{2_{n-\Delta 1}}.$$

**4.** Power estimation method according to claim 3, comprising the step, if $\Delta 1$ is not an integer, of calculating the estimated value by making a linear interpolation between the second voltage sample $V_{2n-INT(\Delta 1)-1}$ and the second voltage sample $V_{2n-INT(\Delta 1)}$, INT being the integer part function.

**5.** Power estimation method according to claim 1, wherein the reconstitution comprises the steps of:

acquiring a prerecorded reference table and containing reference samples of a sinusoidal signal;
measuring a maximum value of the second phase voltage and multiplying the reference samples by an amplitude factor proportional to the maximum value to obtain resulting reference samples, and
for each first estimated voltage sample associated with a first index, conferring to the first estimated voltage sample, a value of a resulting reference sample having as an index, the first index offset from an index offset corresponding to the expected theoretical phase shift without fraud between the first phase voltage and the second phase voltage.

**6.** Power estimation method according to one of the preceding claims, wherein the at least one first electrical power comprises a first Active Power estimated from first estimated voltage samples and from first current samples, images over time of a first phase current (I1) circulating on the first phase, and/or a first Reactive Power estimated from samples of a level on a fundamental frequency of the first phase voltage (V1) and from samples of a level on a fundamental frequency of the first phase current (I1), and/or a first Apparent Power estimated from an effective value of the first phase voltage (V1) and from an effective value of the first phase current (I1).

7. Power estimation method according to claim 6, wherein the samples of the level on the fundamental frequency of the first phase voltage (V1) and the samples of the level on the fundamental frequency of the first phase current (I1) are obtained by application of a low-pass filtering respectively on the first estimated voltage samples and on the first current samples.

8. Power estimation method according to claim 7, wherein the low-pass filtering is a first-order Butterworth filter having a Z transform $H(Z)$ such that:

$$H(Z) = \frac{1 + Z^{-1}}{1 - a.Z^{-1}},$$

with:

$$a = 0.7569801925.$$

9. Power estimation method according to one of the preceding claims, further comprising the steps, if the fraud also falsifies the measurements of a third phase voltage (V3), present on a third phase (Ph3), of again using the second voltage samples to reconstitute third estimated voltage samples, images over time of the third phase voltage, and of estimating at least one third electrical power consumed on the third phase by using the third estimated voltage samples.

10. Power estimation method according to one of the preceding claims, further comprising the steps of detecting if the distribution network (3) comprises, or not, a neutral (N) in addition to the three phases and, if this is not the case, of calculating second corrected voltage samples, and of calculating at least one second corrected electrical power consumed on the second phase (Ph2) from the second corrected voltage samples.

11. Power estimation method according to claim 10, wherein the calculation of the second corrected voltage samples comprises the steps of acquiring a second index offset corresponding to an expected theoretical phase shift for the measurements of the second phase voltage (V2) due to fraud, of multiplying the second voltage samples by a predetermined factor to obtain second resulting samples and, for each second corrected voltage sample associated with a second corrected index:

if the second index offset is an integer, of conferring to the second corrected voltage sample, a value of a second resulting voltage sample having, as a second index, the second corrected index offset from the second index offset;
otherwise, of conferring to the second corrected voltage sample, an estimated value obtained from an interpolation using at least one second resulting voltage sample.

12. Power estimation method according to claim 10, wherein an absence of neutral (N) is detected when an angle φ between the second phase voltage (V2) and the third phase voltage (V3) is such that:

$$180° - X° < |\varphi| < 180° + X°,$$

X being a positive predefined value and less than 30.

13. Power estimation method according to one of the preceding claims, wherein fraud is detected when the first phase voltage is less than a predefined voltage threshold, while the first phase current is greater than a predefined current threshold.

14. Three-phase electricity meter, comprising a processing component (6) arranged to implement the power estimation method according to one of the preceding claims.

15. Computer program comprising instruction which causes the processing component (6) of the three-phase electricity meter (1) according to claim 14 to execute the steps of the power estimation method according to one of claims 1 to 13.

16. Recording media which can be read by a computer, on which the computer program is recorded according to claim 15.

Fig. 1

Fig. 2

Fig. 3

Fig. 4

Fig. 5

Fig. 6

E0 — Début

E1 — Détection de fraude sur 1 ou 2 tensions ?

NON

2 — Configuration à 4 fils

E2 — Calcul normal des estimations des puissances P, Q et S sur les 3 phases à partir des échantillons reçus

E3 — Détermination des échantillons virtuels de la 1ère phase manquante à partir de ceux de la phase de référence et estimation des puissances P, Q et S de la 1ère phase manquante

1

E5 — Configuration à 3 fils ou 4 fils ?

3 fils

E6 — Détermination des échantillons corrigés des 2 phases de référence à partir de ceux reçus de ces 2 phases et correction sur le calcul des puissances de ces 2 phases en amplitude et en déphasage

E4 — Détermination des échantillons virtuels de la 2ème phase manquante à partir de ceux de la phase de référence et estimation des puissances P, Q et S de la 2ème phase manquante

4 fils

E8 — Détermination des échantillons virtuels de la phase manquante à partir de ceux d'une des 2 phases de référence et estimation des puissances P, Q et S de la phase manquante

Détermination des échantillons virtuels de la phase manquante à partir de ceux d'une des 2 phases de référence et estimation des puissances P, Q et S de la phase manquante

E7

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0455518 A2
- US 2012306290 A1
- US 6236197 B1